# EUROPEAN PATENT SPECIFICATION

(11) **EP 4 421 868 B1**
(45) Date of publication and mention of the grant of the patent: **25.12.2024**
(21) Application number: 23158107.5
(22) Date of filing: 23.02.2023
(51) Int. Cl.: H01L 25/07, H01L 23/538, H01L 23/373, H01L 23/053, H01L 23/24, H01L 23/48, H01L 23/498

(54) **SEMICONDUCTOR MODULE ARRANGEMENT**
HALBLEITERMODULANORDNUNG
AGENCEMENT DE MODULE SEMI-CONDUCTEUR

(43) Date of publication of application: 28.08.2024
(73) Proprietor: Infineon Technologies AG, 85579 Neubiberg (DE)
(72) Inventor: HOHLFELD, Olaf, 59581 Warstein (DE); MICHALSKI, Sebastian, 13347 Berlin (DE)
(74) Representative: Westphal, Mussgnug & Partner, Patentanwälte mbB

(56) References cited:
- EP-A1- 4 064 340
- US-A1- 2016 056 132
- US-A1- 2020 286 865

## Description

### TECHNICAL FIELD

The instant disclosure relates to a semiconductor module arrangement, in particular to a power semiconductor module arrangement comprising at least one controllable semiconductor element.

### BACKGROUND

Document EP 4 064 340 A1 discloses a power semiconductor module comprising a main substrate, at least one first semiconductor chip mounted on the main substrate, and at least one auxiliary substrate mounted on the main substrate, the at least one auxiliary substrate comprises a top face remote from the main substrate, wherein the at least one auxiliary substrate comprises an insulation layer which is based on an organic material and which is in direct contact with the main substrate, and comprises a top metal layer forming at least part of the top face.

Document US 2016/056132 A1 discloses a circuit arrangement including at least two semiconductor chip having first and second load terminals that are each connected to one another, a first load current collecting conductor track, and also an external terminal electrically conductively connected thereto. For each of the semiconductor chips there is at least one electrical connection conductor electrically conductively connected to the first load terminal of the relevant semiconductor chip and also to the first load current collecting conductor track. The total inductance of all the connection conductors with which the first load terminal of the second of the semiconductor chips is connected to the first load current collecting conductor track has at least twice the inductance of that section of the first load current collecting conductor track which is formed between the second connection location of the first of the semiconductor chips and the second connection location of the second of the semiconductor chips.

Document US 2020/286865 A1 discloses an implementation of a semiconductor package including one or more die coupled over a substrate, an electrically conductive spacer coupled over the substrate, and a clip coupled over and to the one or more die and the electrically conductive spacer. The clip may electrically couple the one or more die and the electrically conductive spacer.

Power semiconductor module arrangements often include at least one semiconductor substrate arranged in a housing. A semiconductor arrangement including a plurality of controllable semiconductor elements (e.g., IGBTs, MOSFETs, HEMTs, etc.) is arranged on each of the at least one substrate. Each substrate usually comprises a substrate layer (e.g., a ceramic layer), a first metallization layer deposited on a first side of the substrate layer, and, optionally, a second metallization layer deposited on a second side of the substrate layer. The controllable semiconductor elements are mounted, for example, on the first metallization layer. The second metallization layer may optionally be attached to a base plate. The layout of the semiconductor arrangement should be chosen to minimize the required size of the at least one substrate while, at the same time, heat that is generated during operation of the power semiconductor module arrangement is efficiently dissipated away from the controllable semiconductor elements and the substrate.

There is a need for a power semiconductor module arrangement that allows to efficiently dissipate heat away from the controllable semiconductor elements, while requiring a minimum of space on a substrate.

### SUMMARY

A power semiconductor module arrangement includes a substrate including a dielectric insulation layer and a first metallization layer arranged on a first side of the dielectric insulation layer, wherein the first metallization layer includes a plurality of different sections that are separate and distinct from each other, a plurality of semiconductor bodies arranged on the first metallization layer, and a connection clip, the connection clip including a layer of an electrically conducting material having a thickness in a vertical direction that is significantly smaller than its length in a first horizontal direction and its width in a second horizontal direction, wherein a first electrode of each of the plurality of semiconductor bodies is electrically coupled to a first section of the first metallization layer, a second electrode of each of the plurality of semiconductor bodies is electrically coupled to a second section of the first metallization layer, a third electrode of each of the plurality of semiconductor bodies is electrically coupled to an additional metallization layer by means of one or more electrical connection elements, the additional metallization layer is arranged distant from and in parallel to the first metallization layer, and the additional metallization layer is arranged on an additional dielectric insulation layer, wherein the additional dielectric insulation layer is arranged in parallel to and distant from the dielectric insulation layer, and wherein the additional dielectric insulation layer is arranged between the additional metallization layer and the first metallization layer. The second electrode of each of the plurality of semiconductor bodies is electrically coupled to the second section of the first metallization layer by means of the connection clip. The additional dielectric insulation layer is coupled to the connection clip by means of a second connection layer, wherein the connection clip is arranged between the additional dielectric insulation layer and the second section of the first metallization layer.

The invention may be better understood with reference to the following drawings and the description. The components in the figures are not necessarily to scale, emphasis instead being placed upon illustrating the principles of the invention. Moreover, in the figures, like referenced numerals designate corresponding parts throughout the different views.

### BRIEF DESCRIPTION OF THE DRAWINGS

Figure 1 is a cross-sectional view of a power semiconductor module arrangement.
Figure 2A is a cross-sectional view of another power semiconductor module arrangement.
Figure 2B is a top view of the power semiconductor module arrangement of Figure 2A.
Figure 3A is a cross-sectional view of another power semiconductor module arrangement.
Figure 3B is a top view of the power semiconductor module arrangement of Figure 3A.
Figure 4 is a cross-sectional view of another power semiconductor module arrangement.
Figure 5A is a cross-sectional view of another power semiconductor module arrangement.
Figure 5B is a top view of the power semiconductor module arrangement of Figure 5A.
Figure 6A is a cross-sectional view of a power semiconductor module arrangement according to embodiments of the disclosure.
Figure 6B is a top view of the power semiconductor module arrangement of Figure 6A.
Figure 7 is a three-dimensional view of the power semiconductor module arrangement of Figures 6A and 6B.

### DETAILED DESCRIPTION

In the following detailed description, reference is made to the accompanying drawings. The drawings show specific examples in which the invention may be practiced. It is to be understood that the features and principles described with respect to the various examples may be combined with each other, unless specifically noted otherwise. In the description, as well as in the claims, designations of certain elements as "first element", "second element", "third element" etc. are not to be understood as enumerative. Instead, such designations serve solely to address different "elements". That is, e.g., the existence of a "third element" does not require the existence of a "first element" and a "second element". An electrical line or electrical connection as described herein may be a single electrically conductive element, or include at least two individual electrically conductive elements connected in series and/or parallel. Electrical lines and electrical connections may include metal and/or semiconductor material, and may be permanently electrically conductive (i.e., non-switchable). A semiconductor body as described herein may be made from (doped) semiconductor material and may be a semiconductor chip or be included in a semiconductor chip. A semiconductor body has electrically connecting pads and includes at least one semiconductor element with electrodes.

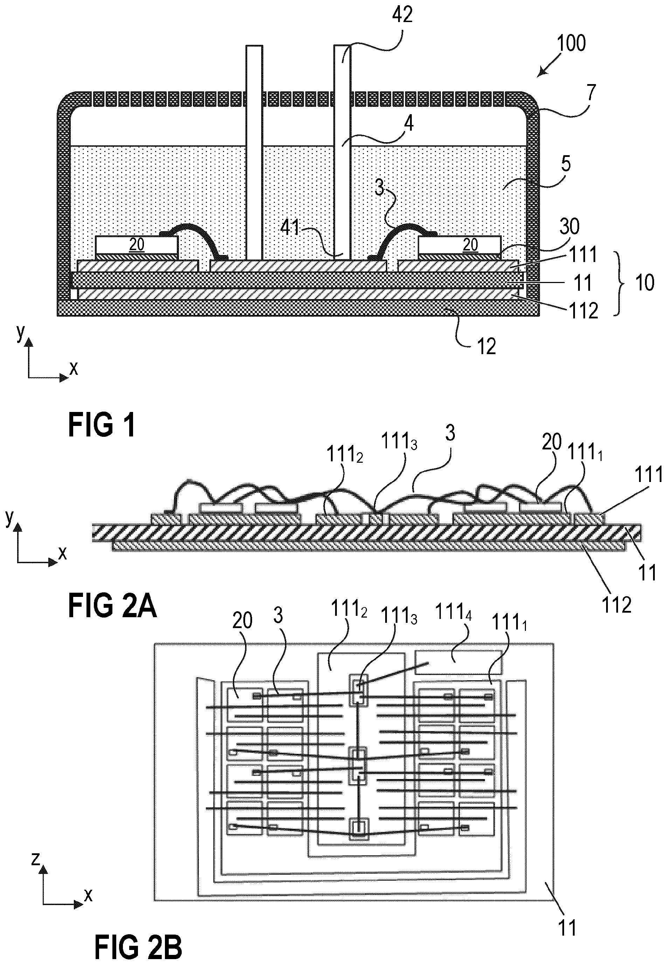

Referring to Figure 1, a cross-sectional view of a power semiconductor module arrangement 100 is schematically illustrated. The power semiconductor module arrangement 100 includes a housing 7 and a substrate 10. The substrate 10 includes a dielectric insulation layer 11, a (structured) first metallization layer 111 attached to the dielectric insulation layer 11, and a (structured) second metallization layer 112 attached to the dielectric insulation layer 11. The dielectric insulation layer 11 is disposed between the first and second metallization layers 111, 112.

Each of the first and second metallization layers 111, 112 may consist of or include one of the following materials: copper; a copper alloy; aluminum; an aluminum alloy; any other metal or alloy that remains solid during the operation of the power semiconductor module arrangement. The substrate 10 may be a ceramic substrate, that is, a substrate in which the dielectric insulation layer 11 is a ceramic, e.g., a thin ceramic layer. The ceramic may consist of or include one of the following materials: aluminum oxide; aluminum nitride; zirconium oxide; silicon nitride; boron nitride; or any other dielectric ceramic. For example, the dielectric insulation layer 11 may consist of or include one of the following materials: Al₂O₃, AlN, SiC, BeO or Si₃N₄. For instance, the substrate 10 may, e.g., be a Direct Copper Bonding (DCB) substrate, a Direct Aluminum Bonding (DAB) substrate, or an Active Metal Brazing (AMB) substrate. Further, the substrate 10 may be an Insulated Metal Substrate (IMS). An Insulated Metal Substrate generally comprises a dielectric insulation layer 11 comprising (filled) materials such as epoxy resin or polyimide, for example. The material of the dielectric insulation layer 11 may be filled with ceramic particles, for example. Such particles may comprise, e.g., SiO₂, Al₂O₃, AlN, or BN and may have a diameter of between about 1µm and about 50µm. The substrate 10 may also be a conventional printed circuit board (PCB) having a non-ceramic dielectric insulation layer 11. For instance, a non-ceramic dielectric insulation layer 11 may consist of or include a cured resin.

The substrate 10 is arranged in a housing 7. In the example illustrated in Figure 1, the substrate 10 is arranged on a base plate 12 which forms a ground surface of the housing 7, while the housing 7 itself solely comprises sidewalls and a cover. This, however, is only an example. It is also possible that the housing 7 further comprises a ground surface and the substrate 10 and the base plate 12 be arranged inside the housing 7. In some power semiconductor module arrangements 100, more than one substrate 10 is arranged on a single base plate 12 or on the ground surface of a housing 7. It is also possible that the substrate 10 itself forms a ground surface of the housing 7.

One or more semiconductor bodies 20 may be arranged on the at least one substrate 10. Each of the semiconductor bodies 20 arranged on the at least one substrate 10 may include a diode, an IGBT (Insulated-Gate Bipolar Transistor), a MOSFET (Metal-Oxide-Semiconductor Field-Effect Transistor), a JFET (Junction Field-Effect Transistor), a HEMT (High-Electron-Mobility Transistor), and/or any other suitable semiconductor element.

The one or more semiconductor bodies 20 may form a semiconductor arrangement on the substrate 10. In Figure 1, only two semiconductor bodies 20 are exemplarily illustrated. The second metallization layer 112 of the substrate 10 in Figure 1 is a continuous layer. The first metallization layer 111 is a structured layer in the example illustrated in Figure 1. "Structured layer" means that the first metallization layer 111 is not a continuous layer, but includes recesses between different sections of the layer. Such recesses are schematically illustrated in Figure 1. The first metallization layer 111 in this example includes three different sections. This, however, is only an example. Any other number of sections is possible. Different semiconductor bodies 20 may be mounted to the same or to different sections of the first metallization layer 111. Different sections of the first metallization layer 111 may have no electrical connection or may be electrically connected to one or more other sections using electrical connection elements 3 such as, e.g., bonding wires or bonding ribbons. Electrical connections 3 may also include connection plates, conductor rails, or connection clips, for example, to name just a few examples. The one or more semiconductor bodies 20 may be electrically and mechanically connected to the substrate 10 by a first electrically conductive connection layer 30. The first electrically conductive connection layer 30 may be a solder layer, a layer of an electrically conductive adhesive, or a layer of a sintered metal powder, e.g., a sintered silver powder, for example. According to other examples, it is also possible that the second metallization layer 112 is a structured layer. It is further possible to omit the second metallization layer 112 altogether.

The power semiconductor module arrangement 100 illustrated in Figure 1 further includes terminal elements 4. The terminal elements 4 are electrically connected to the first metallization layer 111 and provide an electrical connection between the inside and the outside of the housing 7. The terminal elements 4 may be electrically connected to the first metallization layer 111 with a first end 41, while a second end 42 of each of the terminal elements 4 protrudes out of the housing 7. The terminal elements 4 may be electrically contacted from the outside at their respective second ends 42. A first part of the terminal elements 4 may extend through the inside of the housing 7 in a vertical direction y. The vertical direction y is a direction perpendicular to a top surface of the substrate 10, wherein the top surface of the substrate 10 is a surface on which the at least one semiconductor body 20 is mounted. The terminal elements 4 illustrated in Figure 1, however, are only examples. Terminal elements 4 may be implemented in any other way and may be arranged anywhere within the housing 7. For example, one or more terminal elements 4 may be arranged close to or adjacent to the sidewalls of the housing 7. Terminal elements 4 could also protrude through the sidewalls of the housing 7 instead of through the cover. The first end 41 of a terminal element 4 may be electrically and mechanically connected to the substrate 10 by an electrically conductive connection layer, for example (not explicitly illustrated in Figure 1). Such an electrically conductive connection layer may be a solder layer, a layer of an electrically conductive adhesive, or a layer of a sintered metal powder, e.g., a sintered silver (Ag) powder, for example. The first end 41 of a terminal element 4 may also be electrically coupled to the substrate 10 via one or more electrical connections 3, for example.

The power semiconductor module arrangement 100 may further include an encapsulant 5. An encapsulant 5 may consist of or include a silicone gel or may be a rigid molding compound, for example. The encapsulant 5 may at least partly fill the interior of the housing 7, thereby covering the components and electrical connections that are arranged on the substrate 10. The terminal elements 4 may be partly embedded in the encapsulant 5. At least their second ends 42, however, are not covered by the encapsulant 5 and protrude from the encapsulant 5 through the housing 7 to the outside of the housing 7. The encapsulant 5 is configured to protect the components and electrical connections of the power semiconductor module 100, in particular the components arranged on the substrate 10 inside the housing 7, from certain environmental conditions and mechanical damage.

Now referring to Figure 2A, a cross-sectional view of another power semiconductor module arrangement is schematically illustrated. The power semiconductor module arrangement of Figure 2A essentially corresponds to the power semiconductor module arrangement 100 as has been described with respect to Figure 1 above. A housing 7, an encapsulant 5, and terminal elements 4, however, are not specifically illustrated in Figure 2A. Figure 2B schematically illustrates a top view of the power semiconductor module arrangement of Figure 2A.

In particular, Figures 2A and 2B schematically illustrate a substrate 10 comprising a structured first metallization layer 111 arranged on a first side of the dielectric insulation layer 11 and comprising a plurality of different sections that are separate and distinct from each other. The semiconductor bodies 20 are mounted on a first section 111₁ of the first metallization layer 111. Each of the plurality of semiconductor bodies 20 comprises a control electrode and a controllable load path between a first load electrode and a second load electrode. The first load electrode of each of the plurality of semiconductor bodies 20 is electrically coupled to the first section 111₁ of the first metallization layer 111, the second load electrode of each of the plurality of semiconductor bodies 20 is electrically coupled to a second section 111₂, of the first metallization layer 111, and the control electrode of each of the plurality of semiconductor bodies 20 is electrically coupled to one or more third sections 111₃ of the first metallization layer 111. In the example of Figures 2A and 2B, three third sections 111₃ are schematically illustrated. The different third sections 111₃ are separate and distinct from each other as well as from each of the other sections of the first metallization layer 111. The different third sections 111₃, however, are all designated as third sections 111₃ herein, as they are all electrically coupled to the control electrode of one or more of the plurality of semiconductor bodies 20. Instead of a plurality (two or more) of separate third sections 111₃, a single third section 111₃ could be provided instead. In the arrangement illustrated in Figures 2A and 2B, the one or more third sections 111₃ are horizontally surrounded by the second section 111₂. That is, the third sections 111₃ form a plurality of islands that are surrounded by the second section 111₂. Instead, the one or more third sections 111₃ could also be arranged beside the second section 111₂ in any other way. All of the different sections of the first metallization layer 111, however, are arranged on the dielectric insulation layer 11 and in one and the same plane. This requires a significant amount of space on the dielectric insulation layer 11. The size of the dielectric insulation layer 11 in the power semiconductor module of Figures 2A and 2B is chosen to be able to accommodate all of the different sections of the first metallization layer 111. The substrate 10, therefore, has a comparably large size and the overall costs of the power semiconductor module are comparably high.

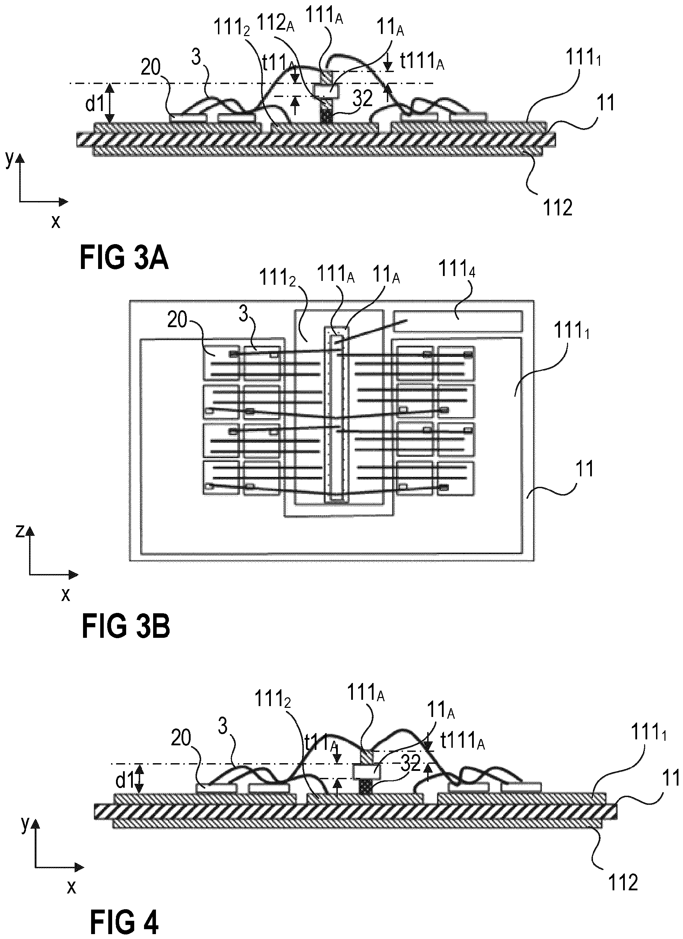

Now referring to Figures 3A and 3B, a power semiconductor module arrangement according to embodiments of the disclosure is schematically illustrated, wherein Figure 3A schematically illustrates a cross-sectional view, and Figure 3B schematically illustrates a top view of the exemplary power semiconductor module arrangement. The power semiconductor module arrangement, instead of the one or more third sections 111₃ arranged on the dielectric insulation layer 11, comprises an additional metallization layer 111_{A} arranged in parallel to and distant from the first metallization layer 111. The additional metallization layer 111_{A} is not arranged in the same plane as the first metallization layer 111. Instead, the additional metallization layer 111_{A} is arranged vertically above the first metallization layer 111. That is, a distance d1 between the first metallization layer 111 and the additional metallization layer 111_{A} in the vertical direction y is greater than zero. For example, the distance d1 may be at least 60µm, at least 100µm, or at least 150µm. The distance d1, however, may be less than 1000µm, or less than 500µm, for example. The distance d1 may be defined by the components that are arranged between the first metallization layer 111 and the additional metallization layer 111_{A} (e.g., connection layer, dielectric insulation layer, connection clip, etc.), as will be described in further detail below.

The semiconductor bodies 20 each may comprise a controllable semiconductor element, For example, the semiconductor bodies 20 may be implemented as IGBTs (Insulated-Gate Bipolar Transistor), MOSFETs (Metal-Oxide-Semiconductor Field-Effect Transistor), JFETs (Junction Field-Effect Transistor), HEMTs (High-Electron-Mobility Transistor), and/or any other suitable controllable semiconductor elements. That is, each semiconductor body 20 comprises a first electrode, a second electrode and a third electrode, wherein the first electrode, the second electrode, and the third electrode are each a different one of the first load electrode, the second electrode, and the control electrode. The first load electrodes of the plurality of semiconductor bodies 20 may be drain electrodes, the second load electrodes of the semiconductor bodies 20 may be source electrodes, and the control electrodes of the semiconductor bodies 20 may be gate electrodes. According to another example, the first load electrodes of the plurality of semiconductor bodies 20 may be collector electrodes, the second load electrodes of the semiconductor bodies 20 may be emitter electrodes, and the control electrodes of the semiconductor bodies 20 may be base electrodes. According to one embodiment of the disclosure, the plurality of semiconductor bodies 20 are all of the same kind. That is, each of the plurality of semiconductor bodies 20 may be or may comprise an IGBTs, for example. It is, however, also possible that the plurality of semiconductor bodies 20 comprises two different kinds of controllable semiconductor elements.

The first load electrode of each of the plurality of semiconductor bodies 20 may be electrically coupled to the first section 111₁ of the first metallization layer (111) by means of a first electrically conductive connection layer 30. The first electrically conductive connection layer 30 may be a solder layer, a layer of an electrically conductive adhesive, or a layer of a sintered metal powder, e.g., a sintered silver (Ag) powder, for example. The second load electrode of each of the plurality of semiconductor bodies 20 may be electrically coupled to the second section 111₂ of the first metallization layer 111 by means of one or more electrical connection elements 3 such as, e.g., bonding wires or bonding ribbons. The control electrode of each of the plurality of semiconductor bodies 20 may be electrically coupled to the additional metallization layer 111_{A} by means of one or more electrical connection elements 3.

As the additional metallization layer 111_{A} is arranged in an additional plane in parallel to the first metallization layer 111, less space is required on the dielectric insulation layer 11. The semiconductor bodies 20, during operation, generally generate a significant amount of heat. This heat is dissipated away from the semiconductor bodies 20 through the dielectric insulation layer 11, e.g., towards a heat sink (not specifically illustrated). The additional metallization layer 111_{A} is not directly coupled to the dielectric insulation layer 11. Any heat generated on the additional metallization layer 111_{A}, therefore, may not be conducted away as efficiently as heat generated on the first metallization layer 111. However, as the additional metallization layer 111_{A} is electrically coupled to the control electrodes of the semiconductor bodies 20, only control signals are conducted through the additional metallization layer 111_{A}. Control signals usually comprise electrical signals of 15V or less and are configured to control the function of the different semiconductor bodies 20. Control signals, however, may also comprise electrical signals of more than 15V. In any case, however, control signals comprise electrical signals of voltages and currents that are significantly lower than the common supply voltages / load currents. The power semiconductor module arrangement may switch from an off state (non-working state) to an on state (working state), for example, when a supply voltage is provided. Supply voltages may be voltages of more than 100V, for example. Due to the comparably low voltages and low currents of the control signals only an insignificant amount of heat is generated in the additional metallization layer 111_{A}. Arranging the additional metallization layer 111_{A} distant from the dielectric insulation layer 11, therefore, is not critical in view of overheating.

In the embodiments of the disclosure described with respect to Figures 3A and 3B, the additional metallization layer 111_{A} is arranged on an additional dielectric insulation layer 11_{A}, wherein the additional dielectric insulation layer 11_{A} is arranged in parallel to and distant from the dielectric insulation layer 11, and wherein the additional dielectric insulation layer 11_{A} is arranged between the additional metallization layer 111_{A} and the first metallization layer 111. In this way, the additional metallization layer 111_{A} is electrically insulated from the first metallization layer 111. The additional dielectric insulation layer 11_{A} may be coupled to the first metallization layer 111 by means of a second connection layer 32. The second connection layer 32 may be a solder layer, a layer of an electrically conductive adhesive, a layer of an electrically insulating adhesive, or a layer of a sintered metal powder. In the example illustrated in Figure 3A, an additional second metallization layer 112_{A} is arranged between the additional dielectric insulation layer 11_{A} and the second connection layer 32. Therefore, solder or sintering techniques may be used, for example, in order to couple the additional dielectric insulation layer 11_{A} with the additional second metallization layer 112_{A} arranged thereon to the first metallization layer 111. It is, however, also possible to glue the additional dielectric insulation layer 11_{A} with the additional second metallization layer 112_{A} arranged thereon to the first metallization layer 111, using an electrically conductive or an electrically insulating adhesive, for example.

It is also possible that the additional second metallization layer 112_{A} be omitted, as is schematically illustrated in Figure 4. That is, the additional dielectric insulation layer 11_{A} may be directly attached to the first metallization layer 111. In this case, soldering or sintering the additional dielectric insulation layer 11_{A} to the first metallization layer 111 may not be possible. The additional dielectric insulation layer 11_{A} may be glued to the first metallization layer 111 using an electrically conducting or an electrically insulating adhesive, for example. The additional second metallization layer 112_{A} generally has no function that is required for the operation of the power semiconductor module. That is, the sole function of the additional second metallization layer 112_{A} may be to facilitate mounting the additional dielectric insulation layer 11_{A} with the additional metallization layer 111_{A} arranged thereon to the first metallization layer 111.

The additional dielectric insulation layer 11_{A} may be arranged on and mechanically coupled to the second section 111₂ of the first metallization layer 111. It is, however, also possible to arrange the additional dielectric insulation layer 11_{A} on any other section of the first metallization layer 111. As is schematically illustrated in Figure 3B, for example, the additional metallization layer 111_{A} may be electrically coupled to a fourth section 111₄ of the first metallization layer 111 by means of one or more electrical connection elements 3. The fourth section 111₄ of the first metallization layer 111 may be electrically contacted by means of one or more terminal elements 4, as has been described with respect to Figure 1 above, for example (terminal elements not specifically illustrated in Figure 3B).

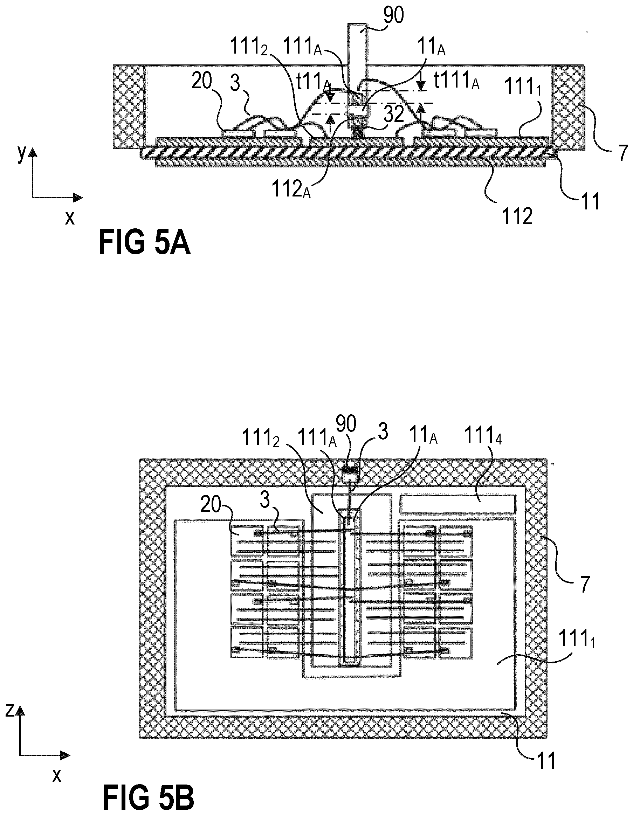

Alternatively, it is also possible that the additional metallization layer 111_{A} be electrically coupled to a terminal element 90 extending vertically through a sidewall of the housing 7, as is schematically illustrated in Figures 5A and 5B. The additional metallization layer 111_{A} may be electrically coupled to the terminal element 90 by means of one or more electrical connection elements 3, for example. The terminal element 90 may be molded into the sidewall of the housing 7, for example, or may be arranged in a vertical hole extending through the sidewall of the housing 7. The additional metallization layer 111_{A}, however, may also be electrically contacted from outside of the housing 7 in any other suitable way. For example, the additional metallization layer 111_{A} may be electrically contacted by mans of terminal elements 4, similar to what has been described with respect to Figure 1 above.

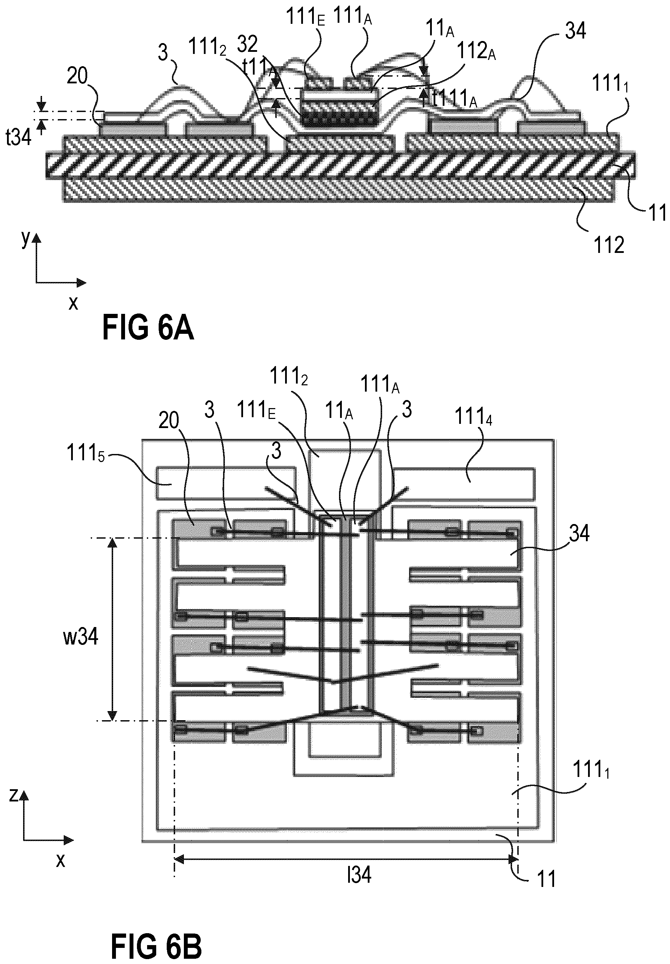

Arranging the additional metallization layer 111_{A} on an additional dielectric insulation layer 11_{A} and mounting the additional dielectric insulation layer 11_{A} to a section of the first metallization layer 111, however, is only an example. Now referring to Figures 6A and 6B which illustrate a power semiconductor module arrangement according to embodiments of the disclosure, the power semiconductor module arrangement comprises a connection clip 34. The connection clip 34 comprises a layer of an electrically conducting material having a thickness t34 in a vertical direction y that is significantly smaller than its length l34 in a first horizontal direction x and its width w34 in a second horizontal direction z. For example, the thickness t34 of the connection clip 34 may be between 50µm and 300µm. The length l34 and width w34 of the connection clip 34 may be in the range of several millimeters up to several tens of millimeters, for example. The connection clip 34 may comprise or consist of copper, for example. Any other electrically conducting materials, however, are also possible. The connection clip 34 can essentially be regarded as an extensive metallic layer that is used to electrically couple the second load electrode of each of the plurality of semiconductor bodies 20 to the second section 1112 of the first metallization layer 111. The connection clip 34 may have any suitable regular or irregular shape. Instead of electrical connection elements 3 such as, e.g., bonding wires or bonding ribbons (see, e.g., Figures 3, 4 and 5), the connection clip 34 is used to electrically couple the second load electrode of each of the plurality of semiconductor bodies 20 to the second section 111₂ of the first metallization layer 111. The connection clip 34 may replace any other kind of electrical connection elements 3. One electrical connection element 3 usually electrically couples a single semiconductor body 20 to the respective section of the first metallization layer 111. The extensive connection clip 34 electrically couples a plurality of semiconductor bodies 20 to one and the same section of the first metallization layer 111.

As the connection clip 34 is an extensive element, it provides a surface area (surface facing away from the substrate 10) that is large enough to easily accommodate the additional dielectric insulation layer 11_{A} with the additional metallization layer 111_{A} arranged thereon. As is schematically illustrated in the cross-sectional view of Figure 6A, the additional metallization layer 111_{A} is arranged on the connection clip 34, with the additional dielectric insulation layer 11_{A} arranged between the connection clip 34 and the additional metallization layer 111_{A}. Similar to what has been described above, an additional second metallization layer 112_{A} may be arranged between the additional dielectric insulation layer 11_{A} and the connection clip 34. The additional second metallization layer 112_{A}, however, can also be omitted. The additional dielectric insulation layer 11_{A} with the additional metallization layer 111_{A} arranged thereon may be mounted to the connection clip 34 similar to what has been described above with respect to Figures 3, 4 and 5. That is, the additional dielectric insulation layer 11_{A} may be attached to the connection clip 34 (instead of to the first metallization layer 111) by means of a second connection layer 32. If the additional second metallization layer 112_{A} is present, the second connection layer 32 may be a solder layer, a layer of an electrically conductive adhesive, a layer of an electrically insulating adhesive, or a layer of a sintered metal powder, for example. If the additional second metallization layer 112_{A} is omitted, the additional dielectric insulation layer 11_{A} may be glued to the connection clip 34, using an electrically conductive or an electrically insulating adhesive, for example.

The additional dielectric insulation layer 11_{A} with the additional metallization layer 111_{A} and the optional additional second metallization layer 112_{A} arranged thereon may be implemented as a so-called flex-board (flexible printed circuit board). Conventional stiff or rigid printed circuit boards could also be used, for example. That is, the additional dielectric insulation layer 11_{A} may consist of a polymer, for example. The dielectric insulation layer 11 on the other hand, may consist of a ceramic material, similar to what has been described with respect to Figure 1 above. The substrate 10, however, may also be a conventional printed circuit board (PCB) having a non-ceramic dielectric insulation layer 11. For instance, a non-ceramic dielectric insulation layer 11 may consist of or include a cured resin. It is, however, generally also possible that the additional dielectric insulation layer 11_{A} is a ceramic layer, similar to the dielectric insulation layer 11. That is, the additional dielectric insulation layer 11_{A} with the additional metallization layer 111_{A} and the optional additional second metallization layer 112_{A} arranged thereon may also be implemented as a conventional ceramic substrate (e.g., IMS, FPC, DCB, AMB, Al₂O₃, AlN, or Si₃N₄ substrate). The additional dielectric insulation layer 11_{A} generally provides sufficient dielectric insulation between the additional metallization layer 111_{A} and the first metallization layer 111, or between the additional metallization layer 111_{A} and the connection clip 34. As has been described above, the additional metallization layer 111_{A} carries comparably small voltages and currents. The requirements concerning dielectric insulation, therefore, are comparably low.

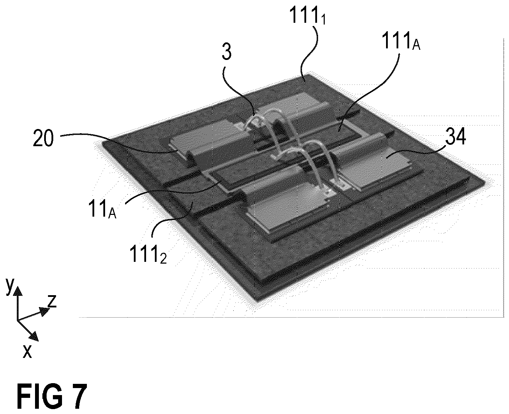

As is illustrated in Figures 3, 4 and 5, only the additional metallization layer 111_{A} may be provided on the surface of the additional dielectric insulation layer 11_{A} facing away from the substrate 10. Figure 7 schematically illustrates a three-dimensional view of an embodiment similar to the embodiment of Figure 6 comprising only the additional metallization layer 111_{A} on the surface of the additional dielectric insulation layer 11_{A} facing away from the substrate 10. It is, however, also possible that further metallization layers are provided on the additional dielectric insulation layer 11_{A}. This is exemplarily illustrated in Figures 6A and 6B. In this example, one further metallization layer 111_{E} is arranged on the surface of the additional dielectric insulation layer 11_{A} facing away from the substrate 10. This further metallization layer 111_{E} may be electrically coupled to an auxiliary emitter of each of the plurality of semiconductor bodies 20 by means of one or more electrical connection elements 3, for example. The further metallization layer 111_{E} is only specifically illustrated with regard to the embodiments comprising a connection 34, but may be implemented in similar ways in other embodiments not comprising a connection clip 34. The at least one further metallization layer 111_{E} may be electrically coupled to a respective section 111₅ of the first metallization layer 111 by means of one or more electrical connection elements 3, for example, similar to what has been described with respect to the additional metallization layer 111_{A} (see, e.g., Figure 6B). The at least one further metallization layer 111_{E}, however, can also be electrically contacted in any other suitable way.

Now referring to all Figures 3 to 6, the additional metallization layer 111_{A}, and any further metallization layers 111_{E} arranged on the additional dielectric insulation layer 11A, may have a thickness t111_{A} in the vertical direction y of up to 35µm, up to 50µm, up to 75µm, or up to 500µm. For example, the thickness t111_{A} of the additional metallization layer 111_{A} may be between 20µm and 500µm for ceramic substrates or conventional printed circuit boards, or between 35µm to 75µm, possibly even between 35µm and 105µm for flex-boards. The additional metallization layer 111_{A} may comprise or consist of copper or aluminum, for example. The same applies for the optional additional second metallization layer 112_{A}. The additional dielectric insulation layer 11_{A} may have a thickness t11_{A} in the vertical direction y of at least 50µm, at least 100µm, or at least 150µm.

A cross-sectional area of the dielectric insulation layer 11 may be significantly larger than a cross-sectional area of the additional dielectric insulation layer 11_{A}. For example, the cross-sectional area of the dielectric insulation layer 11 may be at least ten times or at least 20 times larger than a cross-sectional area of the additional dielectric insulation layer 11_{A}.

The additional dielectric insulation layer 11_{A} with the additional metallization layer 111_{A}, the (optional) additional second metallization layer 112_{A}, and any further metallization layers 111_{E} arranged thereon may be mounted to a connection clip 34 before the connection clip 34 is stamped (cut) from a large metal sheet, or after the connection clip 34 has been stamped (cut) from a large metal sheet but before it has been bent in any way, or after stamping (cutting) and bending the connection clip 34 but before mounting it to the substrate 10, or even after mounting the connection clip 34 to the substrate 10.

In the examples described above, the control electrode of each of the plurality of semiconductor bodies 20 is electrically coupled to an additional metallization layer 111_{A}, while the first load electrode and the second load electrode of each of the semiconductor bodies 20 is electrically coupled to a respective section of the first metallization layer 111 arranged on the dielectric insulation layer 11. However, it is generally also possible that instead of the control electrodes, the first load electrodes or the second load electrodes of the semiconductor bodies 20 are electrically coupled to the additional metallization layer 111_{A}. For example, the first load electrodes of the plurality of semiconductor bodies 20 may be electrically coupled to a first section 111₁ of the first metallization layer 111, the control electrodes of the plurality of semiconductor bodies 20 may be electrically coupled to a second section 111₂ of the first metallization layer 111, and the second load electrodes of the plurality of semiconductor bodies 20 may be electrically coupled to the additional metallization layer 111_{A}. Generally speaking, a first electrode (e.g., gate, emitter, collector, source, drain) may be electrically coupled to the additional metallization layer 111_{A}, while a second and a third electrode of the plurality of semiconductor bodies 20, which are different from the first electrode, are electrically coupled to respective sections of the first metallization layer 111.

## Claims

1. A power semiconductor module arrangement comprises,
a substrate (10) comprising a dielectric insulation layer (11) and a first metallization layer (111) arranged on a first side of the dielectric insulation layer (11), wherein the first metallization layer (111) comprises a plurality of different sections that are separate and distinct from each other;
a plurality of semiconductor bodies (20) arranged on the first metallization layer (111); and
a connection clip (34), the connection clip (34) comprising a layer of an electrically conducting material having a thickness (t34) in a vertical direction (y) that is significantly smaller than its length (l34) in a first horizontal direction (x) and its width (w34) in a second horizontal direction (z), wherein
a first electrode of each of the plurality of semiconductor bodies (20) is electrically coupled to a first section (111₁) of the first metallization layer (111),
a second electrode of each of the plurality of semiconductor bodies (20) is electrically coupled to a second section (111₂) of the first metallization layer (111),
a third electrode of each of the plurality of semiconductor bodies (20) is electrically coupled to an additional metallization layer (111_{A}) by means of one or more electrical connection elements (3),
the additional metallization layer (111_{A}) is arranged distant from and in parallel to the first metallization layer (111),
the additional metallization layer (111_{A}) is arranged on an additional dielectric insulation layer (11_{A}), wherein the additional dielectric insulation layer (11_{A}) is arranged in parallel to and distant from the dielectric insulation layer (11), and wherein the additional dielectric insulation layer (11_{A}) is arranged between the additional metallization layer (111_{A}) and the first metallization layer (111),
the second electrode of each of the plurality of semiconductor bodies (20) is electrically coupled to the second section (111₂) of the first metallization layer (111) by means of the connection clip (34), and
the additional dielectric insulation layer (11_{A}) is coupled to the connection clip (34) by means of a second connection layer (32), wherein the connection clip (34) is arranged between the additional dielectric insulation layer (11_{A}) and the second section (111₂) of the first metallization layer (111).

2. The power semiconductor module arrangement of claim 1, wherein
the first electrode of each of the plurality of semiconductor bodies (20) is electrically coupled to the first section (111₁) of the first metallization layer (111) by means of a first electrically conductive connection layer (30);
the second electrode of each of the plurality of semiconductor bodies (20) is electrically coupled to the second section (111₂) of the first metallization layer (111) by means of one or more electrical connection elements (3); and
the third electrode of each of the plurality of semiconductor bodies (20) is electrically coupled to the additional metallization layer (111_{A}) by means of one or more electrical connection elements (3).

3. The power semiconductor module arrangement of claim 2, wherein an electrical connection element (3) comprises a bonding wire, a bonding ribbon, a connection plate, a conductor rail, or a connection clip.

4. The power semiconductor module arrangement of any of the preceding claims, wherein
each of the plurality of semiconductor bodies (20) comprises a control electrode and a controllable load path between a first load electrode and a second load electrode, and
the first electrode, the second electrode, and the third electrode are each a different one of the first load electrode, the second load electrode, and the control electrode.

5. The power semiconductor module arrangement of any of the preceding claims, wherein the additional metallization layer (111_{A}) is electrically coupled to a fourth section (1114) of the first metallization layer (111) by means of one or more electrical connection elements (3).

6. The power semiconductor module arrangement of any of claims 1 to 4, further comprising a housing (7) and a terminal element (90) extending vertically through a sidewall of the housing (7), wherein the additional metallization layer (111_{A}) is electrically coupled to the terminal element (90) by means of one or more electrical connection elements (3).

7. The power semiconductor module arrangement of any of the preceding claims, wherein the dielectric insulation layer (11) consists of a ceramic material, and the additional dielectric insulation layer (11_{A}) consists of a polymer or a ceramic material.

8. The power semiconductor module arrangement of any of the preceding claims, wherein the additional metallization layer (111_{A}) has a thickness (t111_{A}) in the vertical direction (y) of up to 35µm, up to 50µm, up to 75µm, or up to 500µm.

9. The power semiconductor module arrangement of any of the preceding claims, wherein the additional dielectric insulation layer (11_{A}) has a thickness (t11_{A}) in the vertical direction (y) of at least 50µm, at least 100µm, or at least 150µm.

## Patentansprüche

1. Leistungshalbleitermodulanordnung, umfassend
ein Substrat (10), umfassend eine dielektrische Isolationsschicht (11) und eine erste Metallisierungsschicht (111), die auf einer ersten Seite der dielektrischen Isolationsschicht (11) angeordnet ist, wobei die erste Metallisierungsschicht (111) mehrere verschiedene Abschnitte umfasst, die voneinander getrennt und unterschiedlich sind;
mehrere Halbleiterkörper (20), die auf der ersten Metallisierungsschicht (111) angeordnet sind; und
eine Verbindungsklammer (34), wobei die Verbindungsklammer (34) eine Schicht aus einem elektrisch leitenden Material mit einer Dicke (t34) in einer vertikalen Richtung (y), die wesentlich kleiner ist als ihre Länge (134) in einer ersten horizontalen Richtung (x) und ihre Breite (w34) in einer zweiten horizontalen Richtung (z), umfasst, wobei
eine erste Elektrode jedes der mehreren Halbleiterkörper (20) elektrisch mit einem ersten Abschnitt (111₁) der ersten Metallisierungsschicht (111) gekoppelt ist,
eine zweite Elektrode jedes der mehreren Halbleiterkörper (20) elektrisch mit einem zweiten Abschnitt (111₂) der ersten Metallisierungsschicht (111) gekoppelt ist,
eine dritte Elektrode jedes der mehreren Halbleiterkörper (20) mittels eines oder mehrerer elektrischer Verbindungselemente (3) elektrisch mit einer zusätzlichen Metallisierungsschicht (111_{A}) gekoppelt ist,
die zusätzliche Metallisierungsschicht (111_{A}) beabstandet von und parallel zu der ersten Metallisierungsschicht (111) angeordnet ist,
die zusätzliche Metallisierungsschicht (111_{A}) auf einer zusätzlichen dielektrischen Isolationsschicht (11_{A}) angeordnet ist, wobei die zusätzliche dielektrische Isolationsschicht (11_{A}) parallel zu und beabstandet von der dielektrischen Isolationsschicht (11) angeordnet ist und wobei die zusätzliche dielektrische Isolationsschicht (11_{A}) zwischen der zusätzlichen Metallisierungsschicht (111_{A}) und der ersten Metallisierungsschicht (111) angeordnet ist,
die zweite Elektrode jedes der mehreren Halbleiterkörper (20) mittels der Verbindungsklammer (34) elektrisch mit dem zweiten Abschnitt (111₂) der ersten Metallisierungsschicht (111) gekoppelt ist und
die zusätzliche dielektrische Isolationsschicht (11_{A}) mittels einer zweiten Verbindungsschicht (32) mit der Verbindungsklammer (34) gekoppelt ist, wobei die Verbindungsklammer (34) zwischen der zusätzlichen dielektrischen Isolationsschicht (11_{A}) und dem zweiten Abschnitt (111₂) der ersten Metallisierungsschicht (111) angeordnet ist.

2. Leistungshalbleitermodulanordnung nach Anspruch 1, wobei die erste Elektrode jedes der mehreren Halbleiterkörper (20) mittels einer ersten elektrisch leitfähigen Verbindungsschicht (30) elektrisch mit dem ersten Abschnitt (111₁) der ersten Metallisierungsschicht (111) gekoppelt ist;
die zweite Elektrode jedes der mehreren Halbleiterkörper (20) mittels eines oder mehrerer elektrischer Verbindungselemente (3) elektrisch mit dem zweiten Abschnitt (111₂) der ersten Metallisierungsschicht (111) gekoppelt ist; und
die dritte Elektrode jedes der mehreren Halbleiterkörper (20) mittels eines oder mehrerer elektrischer Verbindungselemente (3) elektrisch mit der zusätzlichen Metallisierungsschicht (111_{A}) gekoppelt ist.

3. Leistungshalbleitermodulanordnung nach Anspruch 2, wobei ein elektrisches Verbindungselement (3) einen Bonddraht, ein Bondband, eine Verbindungsplatte, eine Leiterschiene oder eine Verbindungsklammer umfasst.

4. Leistungshalbleitermodulanordnung nach einem der vorhergehenden Ansprüche, wobei
jeder der mehreren Halbleiterkörper (20) eine Steuerelektrode und einen steuerbaren Lastpfad zwischen einer ersten Lastelektrode und einer zweiten Lastelektrode umfasst, und
die erste Elektrode, die zweite Elektrode und die dritte Elektrode jeweils eine andere der ersten Lastelektrode, der zweiten Lastelektrode und der Steuerelektrode sind.

5. Leistungshalbleitermodulanordnung nach einem der vorhergehenden Ansprüche, wobei die zusätzliche Metallisierungsschicht (111_{A}) mittels eines oder mehrerer elektrischer Verbindungselemente (3) elektrisch mit einem vierten Abschnitt (111₄) der ersten Metallisierungsschicht (111) gekoppelt ist.

6. Leistungshalbleitermodulanordnung nach einem der Ansprüche 1 bis 4, ferner umfassend ein Gehäuse (7) und ein Anschlusselement (90), das sich vertikal durch eine Seitenwand des Gehäuses (7) erstreckt, wobei die zusätzliche Metallisierungsschicht (111_{A}) mittels eines oder mehrerer elektrischer Verbindungselemente (3) elektrisch mit dem Anschlusselement (90) gekoppelt ist.

7. Leistungshalbleitermodulanordnung nach einem der vorhergehenden Ansprüche, wobei die dielektrische Isolationsschicht (11) aus einem Keramikmaterial besteht und die zusätzliche dielektrische Isolationsschicht (11_{A}) aus einem Polymer oder einem Keramikmaterial besteht.

8. Leistungshalbleitermodulanordnung nach einem der vorhergehenden Ansprüche, wobei die zusätzliche Metallisierungsschicht (111_{A}) eine Dicke (t111_{A}) in der vertikalen Richtung (y) von bis zu 35 µm, bis zu 50 µm, bis zu 75 µm oder bis zu 500 µm aufweist.

9. Leistungshalbleitermodulanordnung nach einem der vorhergehenden Ansprüche, wobei die zusätzliche dielektrische Isolationsschicht (11_{A}) eine Dicke (t11_{A}) in der vertikalen Richtung (y) von mindestens 50 µm, mindestens 100 µm oder mindestens 150 µm aufweist.

## Revendications

1. Un agencement de module à semiconducteur comprend
un substrat (10) comprenant une couche (11) diélectrique isolante et une première couche (111) de métallisation disposée sur une première face de la couche (11) diélectrique isolante, dans lequel la première couche (111) de métallisation comprend une pluralité de parties différentes, qui sont séparées et distinctes les unes des autres ;
une pluralité de corps (20) à semiconducteur disposés sur la première couche (111) de métallisation ; et
une pince (34) de connexion, la pince (34) de connexion comprenant une couche d'un matériau conducteur de l'électricité d'une épaisseur (t34) dans une direction (y) verticale, qui est significativement plus petite que sa longueur (134) dans une première direction (x) horizontale et que sa largeur (w34) dans une deuxième direction (z) horizontale, dans lequel
une première électrode de chacun de la pluralité de corps (20) à semiconducteur est connectée électriquement à une première partie (111₁) de la première couche (111) de métallisation,
une deuxième électrode de chacun de la pluralité de corps (20) à semiconducteur est connectée électriquement à une deuxième partie (111₂) de la première couche (111) de métallisation,
une troisième électrode de chacun de la pluralité de corps (20) à semiconducteur est connectée électriquement à une couche (111_{A}) supplémentaire de métallisation au moyen d'un ou de plusieurs éléments (3) de connexion électrique,
la couche (111_{A}) supplémentaire de métallisation est disposée à distance de la première couche (111) de métallisation en lui étant parallèle,
la couche (111_{A}) supplémentaire de métallisation est disposée sur une couche (11_{A}) diélectrique isolante supplémentaire, dans lequel la couche (11_{A}) diélectrique isolante supplémentaire est disposée parallèlement à la couche (11) diélectrique isolante et en étant à distance, et dans lequel la couche (11_{A}) diélectrique isolante supplémentaire est disposée entre la couche (111_{A}) supplémentaire de métallisation et la première couche (111) de métallisation,
la deuxième électrode de chacun de la pluralité des corps (20) à semiconducteur est connectée électriquement à la deuxième partie (111₂) de la première couche (111) de métallisation au moyen de la pince (34) de connexion, et
la couche (11_{A}) diélectrique isolante supplémentaire est connectée à la pince (34) de connexion au moyen d'une deuxième couche (32) de connexion, dans lequel la pince (34) de connexion est disposée entre la couche (11_{A}) diélectrique isolante supplémentaire et la deuxième partie (111₂) de la première couche (111) de métallisation.

2. L'agencement de module à semiconducteur de puissance suivant la revendication 1, dans lequel
la première électrode de chacun de la pluralité de corps (20) à semiconducteur est connectée électriquement à la première partie (111₂) de la première couche (111) de métallisation au moyen d'une première couche (30) de connexion conductrice de l'électricité ;
la deuxième électrode de chacun de la pluralité de corps (20) à semiconducteur est connectée électriquement à la deuxième partie (111₂) de la première couche (111) de métallisation au moyen d'un ou plusieurs éléments (3) de connexion électrique ; et
la troisième électrode de chacun de la pluralité de corps (20) à semiconducteur est connectée électriquement à la couche (111_{A}) supplémentaire de métallisation au moyen d'un ou de plusieurs éléments (3) de connexion électrique.

3. L'agencement de module à semiconducteur de puissance suivant la revendication 2, dans lequel un élément (3) de connexion électrique comprend un fil de liaison, un ruban de liaison, une plaque de liaison, un rail conducteur ou une pince de connexion.

4. L'agencement de module à semiconducteur de puissance suivant l'une quelconque des revendications précédentes, dans lequel
chacun de la pluralité de corps (20) à semiconducteur comprend une électrode de commande et un chemin de charge pouvant être commandé entre une première électrode de charge et une deuxième électrode de charge, et
la première électrode, la deuxième électrode et la troisième électrode sont chacune une électrode différente de la première électrode de charge, de la deuxième électrode de charge et de l'électrode de commande.

5. L'agencement de module à semiconducteur de puissance suivant l'une quelconque des revendications précédentes, dans lequel la couche (111_{A}) supplémentaire de métallisation est connectée électriquement à une quatrième partie (111₄) de la première couche (111) de métallisation au moyen d'un ou de plusieurs éléments (3) de connexion électrique.

6. L'agencement de module à semiconducteur de puissance suivant l'une quelconque des revendications 1 à 4, comprenant en outre un boîtier (7) et un élément (90) formant borne traversant verticalement une paroi latérale du boîtier (7), dans lequel la couche (111_{A}) supplémentaire de métallisation est connectée électriquement à l'élément (90) formant borne au moyen d'un ou de plusieurs éléments (3) de connexion.

7. L'agencement de module à semiconducteur de puissance suivant l'une quelconque des revendications précédentes, dans lequel la couche (11) diélectrique isolante consiste en un matériau céramique, et la couche (11_{A}) diélectrique isolante supplémentaire consiste en un matériau polymère ou en un matériau céramique.

8. L'agencement de module à semiconducteur de puissance suivant l'une quelconque des revendications précédentes, dans lequel la couche (111_{A}) supplémentaire de métallisation a une épaisseur (t111_{A}) dans la direction (y) verticale allant jusqu'à 35 µm, jusqu'à 50 µm, jusqu'à 75 µm ou jusqu'à 500 µm.

9. L'agencement de module à semiconducteur de puissance suivant l'une quelconque des revendications précédentes, dans lequel la couche (11_{A}) diélectrique isolante supplémentaire a une épaisseur (t11_{A}) dans la direction (y) verticale d'au moins 50 µm, d'au moins 100 µm ou d'au moins 150 µm.
